(19) **Europäisches Patentamt**

**European Patent Office**

**Office européen des brevets**

(11) **EP 0 634 700 B1**

(12) **EUROPEAN PATENT SPECIFICATION**

(45) Date of publication and mention
of the grant of the patent:
**11.05.2005 Bulletin 2005/19**

(51) Int Cl.⁷: **G03F 7/20**

(21) Application number: **94110918.3**

(22) Date of filing: **13.07.1994**

(54) **Scanning type exposure apparatus**

Abtastbelichtungsvorrichtung

Appareil d'exposition par balayage

(84) Designated Contracting States:
**DE FR NL**

(30) Priority: **14.07.1993 JP 17416193**

(43) Date of publication of application:
**18.01.1995 Bulletin 1995/03**

(73) Proprietor: **NIKON CORPORATION**
**Tokyo (JP)**

(72) Inventor: **Makinouchi, Susumu**
**Zama-shi, Kanagawa-ken (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 0 360 272**      **JP-A- 6 140 305**
**US-A- 5 194 893**

**Description**

BACKGROUND OF THE INVENTION

Field of the Invention

The present invention relates to an exposure apparatus used in a photolithography process in the manufacture of, e.g., a semiconductor element, a liquid crystal display element, a thin-film magnetic head, or the like and, more particularly, to a scanning type exposure apparatus for transferring a pattern on a mask (or a reticle) onto a substrate by synchronously moving the mask and the substrate.

Related Background Art

The Japanese Patent Application Laid Open No. 6-140305, filed on October 26, 1992 and published on May 20, 1994, refers to a scanning type exposure apparatus. According to the disclosure in this application, constant speed drive of a reticle and a wafer in a relative scanning direction and positioning of the reticle and the wafer are simultaneously performed with a high precision by a slit scanning exposure scheme. A reticle side scanning stage for scanning a reticle relative to a slit-like illumination area in the relative scanning direction is placed on a reticle side base. A reticle side fine adjustment stage for moving and rotating the reticle within a two-dimensional ptane is placed on the reticle side scanning stage. The reticle is placed on the reticle side fine adjustment stage. Constant speed drive and positioning of the reticle and a wafer are performed by independently controlling the reticle side scanning stage and the reticle side fine adjustment stage.

EP-A-0 360 272 discloses a stepper for circuit pattern formation.

In the photolithography process in the manufacture of semiconductor elements, a projection exposure apparatus for transferring a pattern formed on a mask or reticle (to be generally referred to as a "reticle" hereinafter) onto a substrate (wafer) coated with a photosensitive material (photoresist) via a projection optical system, in particular, a step-and-repeat type reduction production exposure apparatus (stepper), is popularly used. Recently, in correspondence with an increase in size and a decrease in line width of semiconductor elements, it is required to widen the image field of the projection optical system and to improve the resolution of the projection optical system. However, it is very difficult in terms of design and manufacture to realize both the high resolution and the wide field of the projection optical system. Thus, as disclosed in, e.g., U.S. Patent Nos. 4,747,678, 4,924,257, 5,194,893, and 5,281,996, a scanning type exposure apparatus, which illuminates only a partial area having a predetermined shape (e.g., a rectangular shape, arcuated shape, hexagonal shape, rhombic shape, or the like) on a reticle with light, and exposes a pattern on the reticle onto a wafer by synchronously moving the reticle and wafer in a direction perpendicular to the optical axis of the projection optical system, is receiving a lot of attention. In the scanning type exposure apparatus, even when the image field of the projection optical system is small, a large-area pattern image can be exposed onto the wafer, and the resolution of the projection optical system can be relatively easily improved.

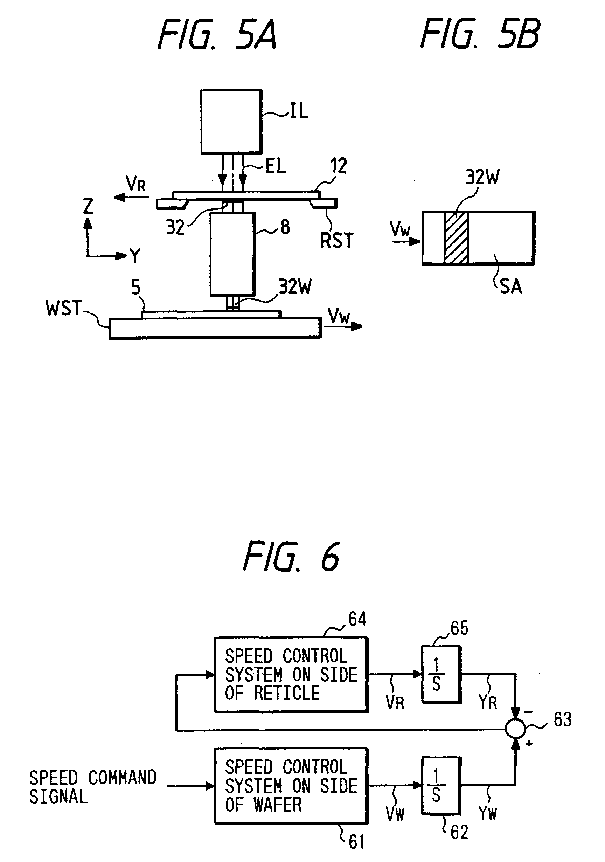

Fig. 5A illustrates a conventional scanning type projection exposure apparatus. Referring to Fig. 5A, exposure light EL emerging from an illumination system IL illuminates an illumination area 32 on a reticle 12 at an even illuminance. A projection optical system 8 projects a pattern in the illumination area 32 on the reticle 12 onto a wafer 5. In scanning exposure, the reticle 12 is moved by a reticle stage RST at a speed $V_R$ in a -Y direction (left direction in the plane of the drawing) with respect to the illumination area 32. In synchronism with this movement, the wafer 5 is moved by a wafer stage WST at a speed $V_W$ (= $\beta \times V_R$, $\beta$: the projection magnification of the projection optical system 8) in a +Y direction (right direction in the plane of the drawing) with respect to a projection area (exposure area similar to the illumination area 32) 32W defined by the projection optical system 8. With these movements, a shot area SA on the wafer 5 is scanned in the Y direction with respect to the exposure area 32W, as shown in Fig. 5B, and the pattern image on the reticle 12 is scanning-exposed on the shot area SA.

Fig. 6 is a functional block diagram showing a control system of the scanning type exposure apparatus shown in Fig. 5A. Referring to Fig. 6, when a speed command signal indicating a scanning speed is input to a speed control system 61 on the side of the wafer, the speed control system 61 drives the wafer stage WST in the Y direction, and performs speed control, so that the moving speed $V_W$ of the wafer stage WST coincides with the speed command. Normally, the position of the wafer stage WST is measured by a laser interferometer. However, in Fig. 6, a speed signal output from the speed control system 61 is supplied to an integrator 62, and the output signal from the integrator 62 is used as a position signal indicating a position $Y_W$, in the Y direction, of the wafer stage WST. On the other hand, a speed signal (a signal indicating the speed $V_R$) output from a speed control system 64 on the side of the reticle is supplied to an integrator 65, and the output signal from the integrator 65 is used as a position signal indicating a position $Y_R$, in the Y direction, of the reticle stage RST. The position signals from the integrators 62 and 65 are input to a subtracter 63, and a signal indicating a positional difference ($Y_W$ - $Y_R$) output from the subtracter 63 is supplied to the speed control system 64. For the sake of simplicity, the projection magnification $\beta$ of the projection optical system 8 is set to be 1.

When the wafer stage WST begins to move by the speed control system 61 to follow the speed command signal, the signal, which indicates the difference between the position $Y_R$ of the reticle stage RST and the position $Y_W$ of the wafer stage WST and is output from the subtracter 63, changes, and is supplied to the speed control system 64 to accelerate the reticle 12 in a direction indicated by the difference. The speed control system 64 comprises a PID controller (proportional, integral, derivative controllers) having an integral function, and the like, and performs acceleration control of the reticle stage RST until the above-mentioned difference ($Y_W$ - $Y_R$) becomes zero. Thus, the reticle 12 and the wafer 5 are synchronously scanned.

However, in the above-mentioned prior art (Fig. 6), the speed command signal is supplied to the speed control system 61 on the side of the wafer, and the signal indicating the difference between the positions $Y_W$ and $Y_R$ of the wafer and reticle stages is supplied to the speed control system 64 on the side of the reticle. More specifically, after the movement of the wafer stage WST is detected, the scanning speed of the reticle stage RST is increased/decreased. For this reason, a time from acceleration of the reticle and wafer to the beginning of synchronous scanning is long.

JP 6-140305 discloses a scanning type exposure apparatus comprising:

an illumination system for illuminating a partial area on a mask with light,

a mask stage which is moveable in a predetermined scanning direction while holding the mask, and

a substrate stage which is movable in the predetermined scanning direction while holding a substrate onto which a pattern on the mask is to be transferred;

wherein a fine movement stage is arranged on the mask stage and is finely moveable relative to the mask stage; a first measuring device for measuring the position, in the predetermined scanning direction, of the fine movement stage, a second measuring device for measuring the position, in the predetermined scanning direction, of the substrate stage, a device for controlling the position of the fine movement stage by a feedback method in correspondence with a difference between the position measured by the first measuring device and the position measured by the second measuring device.

## SUMMARY OF THE INVENTION

It is an object of the present invention to provide a scanning type exposure apparatus which can shorten the time from acceleration of a mask and a substrate to the beginning of synchronous scanning for scanning exposure.

This object is solved by an apparatus comprising the features of claim 1.

The fine movement stage for finely adjusting the position of the mask and the substrate is arranged in addition to the mask stage and the substrate stage, which are used for moving the mask and the substrate at predetermined speeds. Since the speed controller simultaneously supplies a scanning speed command to the mask stage and the substrate stage, only an error caused by a difference between the response characteristics of speed control of the two stages appears as an error between the scanning speeds of the two stages. In contrast to this, in the conventional control method, a sum of a delay time caused by the speed control system on the side of the mask and a delay time caused by the speed control system on the side of the substrate appears in one of the mask stage and the substrate stage.

Furthermore, in order to prevent generation of an error between the relative positions of the mask and the substrate caused by a difference between the response characteristics of the speed control system on the side of the mask and the speed control system on the side of the substrate, the position of the fine movement stage is controlled by the feedback method in correspondence with a difference between the position of the mask stage and the position of the substrate stage. With this control, a time from acceleration of the mask and the substrate to the beginning of synchronous scanning is shortened, and the throughput can be improved. In addition, since the moving distances of the stages before the synchronous scanning can be shortened, the strokes, in the scanning directions, of the stages can be shortened, and the apparatus can be rendered compact.

## BRIEF DESCRIPTION OF THE DRAWINGS

Fig. 1 is a schematic side view showing the arrangement of a scanning type projection exposure apparatus for a better understanding of the present invention;
Fig. 2A is a plan view showing the arrangement of a wafer stage shown in Fig. 1, and Fig. 2B is a plan view showing the arrangement of a reticle stage shown in Fig. 1;
Fig. 3 is a block diagram showing a control system of the apparatus shown in Fig. 1;
Fig. 4 is a functional block diagram showing a control system of stages in Fig. 1;
Fig. 5A is a schematic side view showing a conventional scanning type projection exposure apparatus, and Fig. 5B is an enlarged view showing a shot area on a wafer shown in Fig. 5A; and
Fig. 6 is a functional block diagram showing a control system of stages of the conventional scanning type projection exposure apparatus.

## DESCRIPTION OF THE DRAWINGS

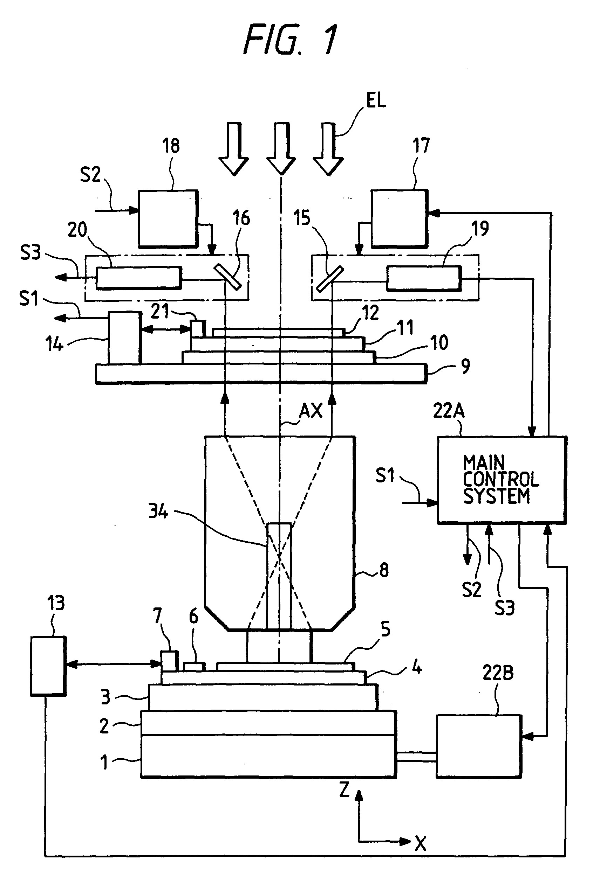

A scanning type projection exposure apparatus for a better understanding of the present invention will be described below with reference to Figs. 1 to 4. Fig. 1 shows the schematic arrangement of a scanning type projection exposure apparatus. Referring to Fig. 1, exposure light EL from an illumination optical system (not shown) is radiated onto only an elongated local rectangular area on a reticle 12. The exposure light EL transmitted through the reticle 12 is incident on a projection optical system 8, and the projection optical system 8 projects an image of a pattern on the reticle 12 onto a wafer 5. In scanning exposure, the reticle 12 is scanned with respect to the illumination area of the exposure light EL at a constant speed $V_R$ in a forward direction (-Y direction) perpendicular to the plane of the drawing of Fig. 1. In synchronism with this movement, the wafer 5 is scanned at a constant speed $\beta \times V_R$ ($\beta$ is the projection magnification of the projection optical system 8) in a backward direction (+Y direction) perpendicular to the plane of the drawing of Fig. 1.

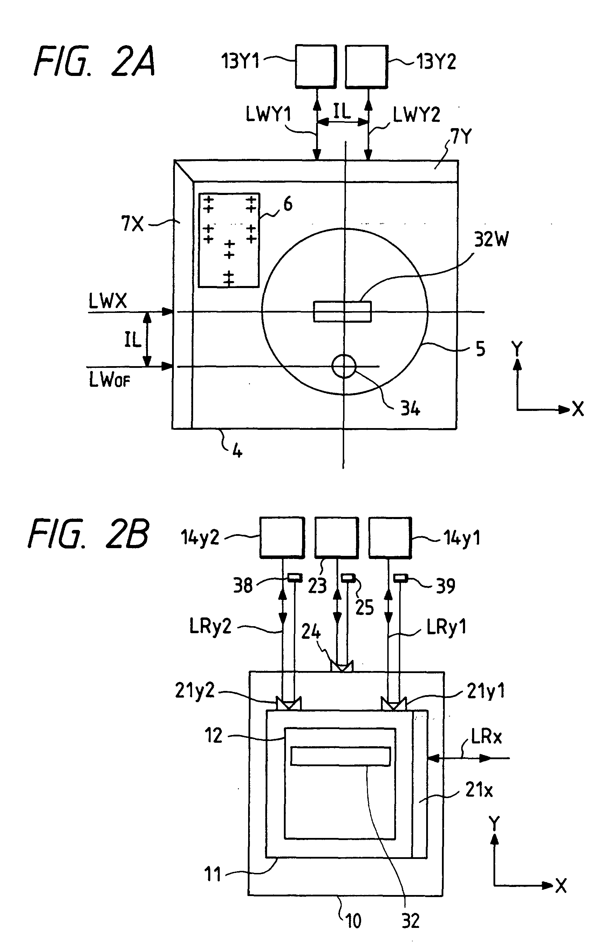

Driving systems of the reticle 12 and the wafer 5 will be described below. A rough movement stage 10, which is movable in only the Y direction (a direction perpendicular to the plane of the drawing of Fig. 1), is arranged on a support table (base) 9, and a fine movement stage 11 is placed on the rough movement stage 10. The reticle 12 is held on the fine movement stage 11 via, e.g., a vacuum chuck. The fine movement stage 11 is finely movable in the X and Y directions and a rotational direction ($\theta$ direction) in a plane perpendicular to an optical axis AX of the projection optical system 8, and performs position control of the reticle 12 with high accuracy. A movable mirror 21 is arranged on the fine movement stage 11, and the positions, in the X, Y, and $\theta$ directions, of the fine movement stage 11 are always monitored by a laser interferometer 14 arranged on the base 9. Position information S1 from the interferometer 14 is supplied to a main control system 22A. As will be described later the position, in the Y direction (scanning direction) of the rough movement stage 10 is always measured by an interferometer (see Fig. 2B).

On the other hand, a Y stage 2, which is movable in the Y direction, is placed on a support table (base) 1, and an X stage 3, which is movable in the X direction, is placed on the Y stage 2. Furthermore, a ZL stage 4, which is finely movable in the direction of the optical axis AX and is arbitrarily tiltable with respect to a plane perpendicular to the optical axis AX, is arranged on the X stage, and the wafer 5 is held on the ZL stage 4 via a vacuum chuck ($\theta$ table; not shown). A movable mirror 7 is fixed on the ZL stage 4, and the positions, in the X, Y, and $\theta$ directions, of the ZL stage 4 are monitored by an externally arranged interferometer 13. Position information from the interferometer 13 is also supplied to the main control system 22A. The main control system 22A controls the alignment operations of the Y stage 2 to the ZL stage 4 via a driver 22B, and the like, and systematically controls the entire apparatus.

In order to establish a correspondence between a wafer coordinate system defined by the interferometer 13 and a reticle coordinate system defined by the interferometer 14, a reference mark plate 6 is fixed at a position, near the wafer 5, on the ZL stage 4. Various reference marks are formed on the reference mark plate 6. One of these reference marks is illuminated, from its back surface side, with illumination light (exposure light) guided to the interior of the ZL stage 4, as disclosed in, e.g., U.S. Patent No. 4,780,616.

Alignment microscopes 19 and 20 for simultaneously observing the reference marks on the reference mark plate 6 and marks on the reticle 12 are equipped above the reticle 12. Also, mirrors 15 and 16 for guiding detection light from the reticle 12 to the alignment microscopes 19 and 20 are movably arranged. When an exposure sequence is started, drivers 17 and 18 retract the mirrors 15 and 16 to positions outside exposure optical paths in accordance with a command from the main control system 22A. Furthermore, an off-axis type alignment device 34 for observing alignment marks (wafer marks) on the wafer 5 is arranged on the side surface portion, in the Y direction, of the projection optical system 8. A detailed description of the alignment device 34 will be omitted since it is disclosed in, e.g., U.S. Patent No. 4,962,318.

The detailed arrangements of the wafer stage and the reticle stage will be described below with reference to Figs. 2A and 2B. Fig. 2A shows the wafer stage. The wafer 5 is held on the ZL stage 4, and the reference mark plate 6 and movable mirrors 7X and 7Y are also arranged on the stage 4. The image of the pattern on the reticle 12 is projected by the projection optical system 8 onto an elongated rectangular exposure area 32W on the wafer 5, which area is similar to the illumination area on the reticle 12.

Referring to Fig. 2A, the movable mirror 7X has a reflection surface extending in the Y direction, and is irradiated with laser beams LWX and $LW_{OF}$ from two X-axis interferometers (not shown) for detecting the position, in the X direction, of the ZL stage 4. The two laser beams LWX and $LW_{OF}$ are separated by an interval IL, are parallel to each other in the X direction, and respectively pass through the optical axis of the projection optical system 8 and a reference point (detection center) of the alignment device 34. On the other hand, the movable mirror 7Y has a reflection surface extending in the X direction, and is irradiated with laser beams LWY1 and LWY2 from two Y-axis interferometers 13Y1 and 13Y2. The laser beams LWY1 and LWY2 are separated by the interval IL and are parallel to each other in the Y direction.

Therefore, as the X-coordinate of the ZL stage 4, a coordinate value measured by the X-axis interferometer using the laser beam LWX is used, and as the Y-coordinate of the ZL stage 4, an average value ($Y_{W1}$

+ $Y_{W2}$)/2 of a coordinate value $Y_{W1}$ measured by the interferometer 13Y1 and a coordinate value $Y_{W2}$ measured by the interferometer 13Y2 is used. In addition, the rotation error (direction and amount) of the ZL stage 4 is calculated on the basis of, e.g., the difference between the coordinate values $Y_{W1}$ and $Y_{W2}$ and the interval IL. Based on these coordinate values, the scanning speed, the position, and the rotational angle, in the XY-plane, of the ZL stage 4 are controlled. In particular, since the moving direction of the ZL stage 4 upon scanning exposure is the Y direction, the average value of the measurement results of the two interferometers 13Y1 and 13Y2 is used in the Y direction, thereby preventing deterioration of accuracy caused by, e.g., inclination upon scanning exposure. The off-axis type alignment device 34 utilizes the measurement value of the X-axis interferometer which does not cause an Abbe's error and uses the laser beam $LW_{OF}$.

Fig. 2B shows the reticle stage. The fine movement stage 11 is placed on the rough movement stage 10, and the reticle 12 is held on the stage 11. On the fine movement stage 11, a movable mirror 21x having a reflection surface which extends in the Y direction and is irradiated with a laser beam LRx from an X-axis interferometer (not shown) for detecting the position in the X direction, and movable mirrors 21y1 and 21y2 which are irradiated with laser beams LRy1 and LRy2 from two Y-axis interferometers 14y1 and 14y2 for detecting the position in the Y direction, are arranged. As the Y-coordinate of the fine movement stage 11, an average value $(Y_{R1} + Y_{R2})/2$ of a coordinate value $Y_{R1}$ measured by the interferometer 14y1 and a coordinate value $Y_{R2}$ measured by the interferometer 14y2 is used, and as the X-coordinate, a coordinate value measured by the X-axis interferometer using the laser beam LRx is used. Furthermore, a rotational error (direction and amount) of the fine movement stage 11 is calculated from, e.g., the difference between the coordinate values $Y_{R1}$ and $Y_{R2}$.

As the movable mirrors 21y1 and 21y2, corner cube type reflection elements are used. The laser beams LRy1 and LRy2 reflected by the movable mirrors 21y1 and 21y2 are respectively reflected by stationary mirrors 39 and 38, and return to the movable mirrors 21y1 and 21y2. More specifically, the Y-axis interferometers 14y1 and 14y2 are double-pass type interferometers, and can prevent position shifts of laser beams even when the fine movement stage 11 is rotated. A rectangular area 32 on the reticle 12 is illuminated with exposure light EL at an even illuminance.

Furthermore, a corner cube type movable mirror 24 is fixed at an end portion, in the Y direction, of the rough movement stage 10. A laser beam from a Y-axis interferometer 23 for the rough movement stage is reflected by the movable mirror 24 toward a stationary mirror 25, and the laser beam reflected by the stationary mirror 25 return to the interferometer 23 via the movable mirror 24. More specifically, the interferometer 23 always monitors a coordinate $Y_{R3}$, in the Y direction, of the rough movement stage 10 by a double-pass method. The fine movement stage 11 is finely movable by an actuator (not shown) in the X, Y, and θ directions relative to the rough movement stage 10.

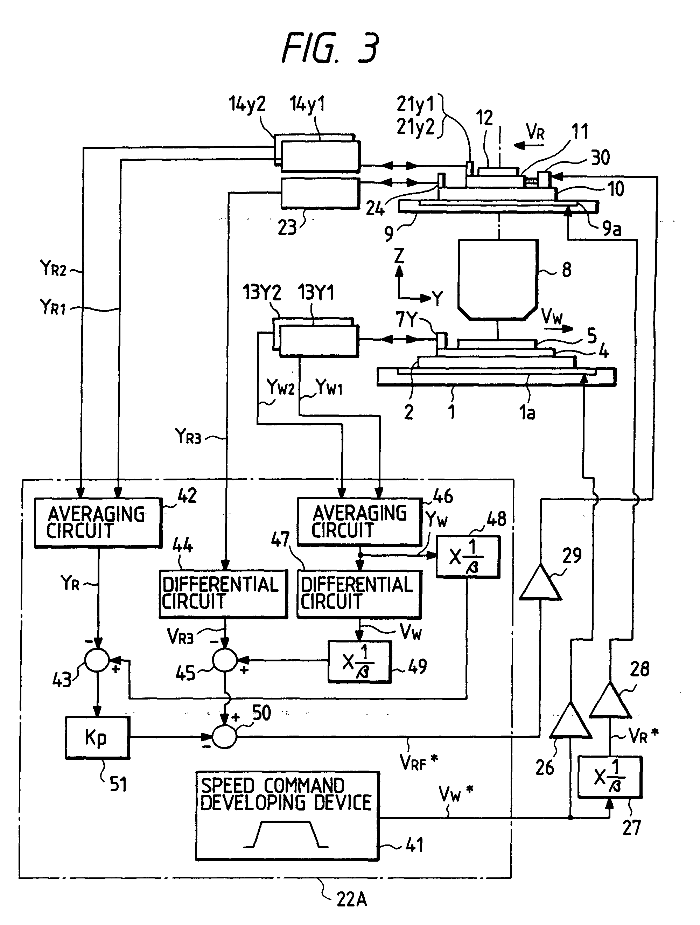

Fig. 3 shows a control system of the apparatus of Fig. 1. Referring to Fig. 3, the rough movement stage 10 is driven by a linear motor 9a in the Y direction with respect to a base 9, and the fine movement stage 11 is driven by a motor 30 in the Y direction with respect to the rough movement stage 10. The Y-coordinates $Y_{R1}$ and $Y_{R2}$ of the fine movement stage 11 measured by the interferometers 14y1 and 14y2, and the Y-coordinate $Y_{R3}$ of the rough movement stage 10 measured by the interferometer 23 are supplied to the main control system 22A. On the other hand, the Y stage 2 on the side of the wafer 5 is driven by a linear motor 1a in the Y direction with respect to the base 1, and the Y-coordinates $Y_{W1}$ and $Y_{W2}$ of the Y stage 2 measured by the interferometers 13Y1 and 13Y2 are supplied to the main control system 22A.

In the main control system 22A, a speed command developing device 41 reads out information of a target scanning speed $V_W^*$ of the wafer stage stored in a memory in synchronism with a predetermined clock signal, and supplies the readout speed information to a power amplifier 26 and a multiplier 27. The power amplifier 26 controls the driving operation of the linear motor 1a, so that the rough movement stage 2 is driven in the Y direction at the target scanning speed $V_W^*$. The multiplier 27 supplies, to a power amplifier 28, information of a target scanning speed $V_R^*$ obtained by multiplying the target scanning speed $V_W^*$ with the reciprocal (1/β) of the projection magnification β of the projection optical system 8. More specifically, the target scanning speed $V_R^*$ of the reticle stage is set to be $V_W^*/β$. For example, the projection magnification β is set to be 1/4. The power amplifier 28 controls the driving operation of the linear motor 9a, so that the rough movement stage 10 is driven at the target scanning speed $V_R^*$ in the -Y direction.

In the main control system 22A, a coordinate $Y_R$ obtained by averaging the Y-coordinates $Y_{R1}$, and $Y_{R2}$ of the fine movement stage 11 by an averaging circuit 42 is supplied to a subtracter 43. Also, the Y-coordinate $Y_{R3}$ of the rough movement stage 10 is supplied to a differential circuit 44, and the differential circuit 44 calculates the difference of the coordinate $Y_{R3}$ from the average value at a predetermined cycle, thereby calculating a scanning speed $V_{R3}$, in the -Y direction, of the rough movement stage 10. The differential circuit 44 supplies the scanning speed $V_{R3}$ to a subtracter 45. Parallel to these operations, a coordinate $Y_W$ obtained by averaging the Y-coordinates $Y_{W1}$ and $Y_{W2}$ of the Y stage 2 by an averaging circuit 46 is supplied to a differential circuit 47 and a multiplier 48. The differential circuit 47 calculates the difference of the coordinate $Y_W$ from the average value at a predetermined cycle, thereby calculating a scanning speed $V_W$, in the Y direction, of the Y stage 2. The circuit 47 supplies the scanning speed $V_W$ to a multiplier 49. The multiplier 49 supplies a scanning speed $V_W/\beta$ obtained by multiplying the scanning speed $V_W$ with the reciprocal ($1/\beta$) of the projection magnification $\beta$ to the subtracter 45, and the multiplier 48 supplies a coordinate value $Y_W/\beta$ obtained by multiplying the Y-coordinate $Y_W$ with the reciprocal ($1/\beta$) to the subtracter 43.

The subtracter 43 supplies the difference $\{(Y_W/\beta) - Y_R\}$ between the Y-coordinate $Y_W/\beta$ of the Y stage 2 and the Y-coordinate $Y_R$ of the fine movement stage 11 on the reticle to a multiplier 51. The multiplier 51 multiplies the difference with a constant $K_P$ to calculate a position gain, and supplies this information to a subtracter 50. The subtracter 45 supplies speed difference information representing the difference $\{(V_W/\beta) - V_{R3}\}$ between the scanning speed $V_W/\beta$ of the Y stage 2 and the scanning speed $V_{R3}$ of the rough movement stage 10 on the reticle to the subtracter 50. The subtracter 50 subtracts the position gain information of the multiplier 51 from the speed difference information of the subtracter 45 to calculate a target scanning speed $V_{RF}^*$, and supplies a signal representing this target scanning speed $V_{RF}^*$ to the motor 30 via the power amplifier 29.

The motor 30 drives the fine movement stage 11 at the target scanning speed $V_{RF}^*$ in the -Y direction with respect to the rough movement stage 10, and the target scanning speed $V_{RF}^*$ is given by:

$$V_{RF}^* = \{(V_W/\beta) - V_{R3}\} - K_P\{(Y_W/\beta) - Y_R\} \qquad (1)$$

More specifically, the target scanning speed $V_{RF}^*$ of the fine movement stage 11 relative to the rough movement stage 10 in the -Y direction is set to be a speed which brings the difference between the speeds of the Y stage 2 and the rough movement stage 10 on the reticle 12, and the difference between the positions of the fine movement stage 11 and the Y stage 2 on the reticle 12 close to zero.

Before the pattern on the reticle 12 is transferred onto the wafer 5, the alignment microscopes 19 and 20 measure, in advance, the positional relationship between the reticle 12 and the reference mark plate 6 on the wafer stage, and the alignment device 34 measures the positional relationship between a shot area on the wafer 5 and the reference mark plate 6. When the pattern on the reticle 12 is transferred onto the shot area on the wafer 5, the measurement values of the interferometers 14y1, 14y2, and 23 on the side of the reticle, and the measurement values of the interferometers 13Y1 and 13Y2 on the side of the wafer are respectively reset to zero upon alignment of the pattern on the reticle 12 to the shot area on the wafer 5. In addition, the polarity of the interferometers on the side of the reticle is set, so that their count values increase when the reticle 12 moves in the -Y direction, and the polarity of the interferometers on the side of the wafer is set, so that their count values increase when the wafer 5 moves in the +Y direction. Thereafter, synchronous scanning of the reticle 12 and the wafer 5 is performed by the control system shown in Fig. 3.

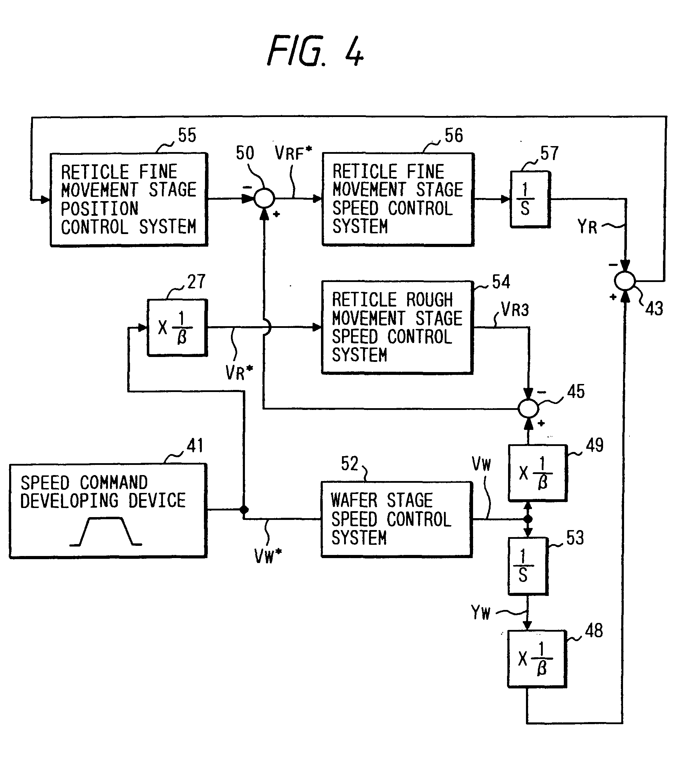

Fig. 4 is a functional block diagram of the control system in correspondence with the format of the functional block diagram in Fig. 6 showing the conventional control system. The same reference numerals in Fig. 4 denote corresponding parts in Fig. 3, and the operation of the entire control systems for the reticle stage and the wafer stage of this embodiment will be described below with reference to Fig. 4.

Referring to Fig. 4, information representing the target scanning speed $V_W^*$ of the wafer stage output from the speed command developing device 41 is supplied to the multiplier 27 which multiplies the input data with the reciprocal ($1/\beta$) of the projection magnification, and a wafer stage speed control system 52. Information representing the scanning speed ($V_W^*/\beta$) output from the multiplier 27 is supplied to a rough movement stage speed control system 54. The speed control system 52 is a control system of the scanning speed for the Y stage 2 in Fig. 3, and the speed control system 54 is a control system of the scanning speed for the rough movement stage 10 in Fig. 3. With these control systems, the Y stage 2 and the rough movement stage 10 are simultaneously accelerated. Since the reticle 11 is placed on the rough movement stage 10 via the fine movement stage 11, the fine movement stage 11 and the reticle 12 are also accelerated at the same time.

Furthermore, in Fig. 4, the scanning speed $V_{R3}$, in the -Y direction, of the rough movement stage 10 measured by the speed control system 54 is supplied to the subtracter 45, and the scanning speed $V_W$, in the Y direction, of the Y stage 2 measured by the speed control system 52 is supplied to the multiplier 49 and an integrator 53. Note that the positions of the stages are measured by the interferometers in the embodiment shown in Fig. 3, but Fig. 4 expresses, for the sake of simplicity, that the speeds are measured, following the custom of the block diagram.

Information of the scanning speed ($V_W/\beta$) output from the multiplier 49 is supplied to the subtracter 45, and information representing the difference $\{(V_W/\beta) - V_{R3}\}$ of the scanning speeds output from the subtracter 45 is supplied to the subtracter 50. Speed information obtained by multiplying the scanning speed $Y_W$, in the Y direction, of the Y stage 2 output from the integrator 53 with the reciprocal ($1/\beta$) of the projection magnification by the multiplier 48 is supplied to the subtracter 43, and information of the scanning speed $Y_R$, in the -Y direction, of the fine movement stage 11 output from a fine movement stage speed control system 56 (to be described later) is also supplied to the subtracter 43. Information of the difference $\{(Y_W/\beta) - Y_R\}$ between the positions output from the subtracter 43 is supplied to a fine movement stage position control system 55. The position control system 55 comprises the multiplier 51 for multiplying input information with the position gain constant $K_P$ in Fig. 3, and supplies information of the difference $K_P \times \{(Y_W/\beta) - Y_R\}$ to the subtracter 50.

Information representing the target scanning speed $V_{RF}^*$ output from the subtracter 50 is supplied to the fine movement stage speed control system 56. The speed control system 56 executes control so that the scanning speed of the fine movement stage 11 in Fig. 3 follows the target scanning speed $V_{RF}^*$, and the target scanning speed $V_{RF}^*$ is given by equation (1) above. Therefore, in this embodiment, since the speed command is parallelly supplied to the wafer stage speed control system 52 and the reticle rough movement stage speed control system 54, a delay of one of the Y stage 2 and the rough movement stage 10 can be prevented.

The reticle 12 is placed on the rough movement stage 10 via the fine movement stage 11, and the driving control of the fine movement stage 11 is achieved by feedback control of the difference between the scanning positions of the Y stage 2 and the fine movement stage 11 on the reticle. Furthermore, the driving control of the fine movement stage 11 is also achieved by feedforward control of the difference between the scanning speeds of the Y stage 2 and the fine movement stage 11 on the reticle. Therefore, the time from the beginning of the scanning to the beginning of synchronous scanning of the reticle 12 and the wafer 5 can be shortened, and the throughput of the exposure process can be improved. In addition, since the moving distances (running distances) required before synchronous scanning are shortened, the strokes, in the Y direction, of the Y stage 2 and the rough movement stage 10 can be shortened, and the entire apparatus can be rendered compact.

Note that the operations of the respective elements in the main control system 22A in Fig. 3 may be executed in a software manner. Components from the wafer stage speed control system 52 to the fine movement stage position control system 55 in Fig. 4 may be constituted by conventional PID controllers (proportional, integral, and derivative controllers), or controllers which are subjected to phase advance/delay compensation. The gain constants (e.g., the position gain constant $K_P$) of the control systems are determined by the mechanical constants of the stages.

In Fig. 3, the reticle 12 is placed on the rough movement stage 10 via the fine movement stage 11. For example, a fine movement stage, which is movable at least in the Y direction relative to the Y stage 2, may be arranged on the Y stage 2, and the wafer 5 may be placed on this fine movement stage. The fine movement stage need not always be arranged between the rough movement stage 10 and the reticle 12 or between the Y stage 2 and the wafer 5. For example, the rough movement stage 10 or the Y stage 2 may be arranged on the fine movement stage, and the fine movement stage may finely move the rough movement stage 10 and the reticle 12 or the Y stage 2 and the wafer 5 integrally in the scanning direction (Y direction in this embodiment). Furthermore, fine movement stages may be arranged on both the sides of the reticle 12 and the wafer 5.

Moreover, the moving speeds of the stages are measured by utilizing the interferometers. For example, the moving speeds of the stages may be measured using speed sensors (or acceleration sensors). When heterodyne laser interferometers are used, since these interferometers detect the moving speeds of objects and the moving distance is calculated by integrating the moving speeds, speed information output from the laser interferometers may be directly used as the moving speeds of the stages.

## Claims

1. A scanning type exposure apparatus comprising:

    an illumination system for ilfuminating a partial area on a mask with light,

    a mask stage which is moveable in a predetermined scanning direction while holding the mask, and

    a substrate stage which is moveable in the predetermined scanning direction while holding a substrate onto which a pattern on the mask is to be transferred;

    wherein each of the mask stage and the substrate stage comprises a fine movement stage which is moveable relative to the mask stage and substrate stage, respectively;
    a first measuring device for measuring the position, in the predetermined scanning direction, of the fine movement stage for the mask stage,
    a second measuring device for measuring the position, in the predetermined scanning direction, of the fine movement stage for the substrate stage,
    a device for controlling the position of each fine movement stage by a feedback method in correspondence with a difference between the position measured by the first measuring device and the position measured by the second measuring device during the scanning exposure.

2. A scanning type exposure apparatus according to claim 1, wherein the first and second measuring device comprises an interferometer system.

3. A scanning type exposure apparatus according to claim 1 or 2, wherein the substrate stage moves in a direction opposite to the movement of the mask stage.

## Patentansprüche

1. Abtastbelichtungsvorrichtung, umfassend:

    ein Beleuchtungssystem zum Belichten eines Teilbereichs auf einer Maske mit Licht,

    eine Maskenbühne, die in einer vorbestimmten Abtastrichtung bewegbar ist, wobei sie die Maske hält, und

    eine Substratbühne, die in der vorbestimmten Abtastrichtung bewegbar ist, wobei sie ein Substrat hält, auf das ein Muster auf der Maske übertragen werden soll;

    worin sowohl die Maskenbühne als auch die Substratbühne eine Feinbewegungsbühne umfasst, die relativ zu der Maskenbühne bzw. der Substratbühne bewegbar ist;
    eine erste Messeinrichtung zum Messen der Position der Feinbewegungsbühne für die Maskenbühne in der vorbestimmten Abtastrichtung,
    eine zweite Messeinrichtung zum Messen der Position der Feinbewegungsbühne für die Substratbühne in der vorbestimmten Abtastrichtung,
    eine Einrichtung zum Steuern der Position jeder Feinbewegungsbühne während der Abtastbelichtung durch ein Rückkopplungsverfahren, entsprechend eines Unterschieds zwischen der Position, die durch die erste Messeinrichtung gemessen wird, und der Position, die durch die zweite Messeinrichtung gemessen wird.

2. Abtastbelichtungsvorrichtung nach Anspruch 1, worin die erste und zweite Messeinrichtung ein Interferometersystem umfassen.

3. Abtastbelichtungsvorrichtung nach Anspruch 1 oder 2, worin die Substratbühne sich in eine Richtung bewegt, die zur Bewegung der Maskenbühne entgegengesetzt ist.

## Revendications

1. Appareil d'exposition du type à balayage comprenant :

    un système d'éclairage pour éclairer une région partielle sur un masque par une lumière,
    un étage de masque qui est mobile dans une direction de balayage prédéterminée tout en contenant le masque, et
    un étage de substrat qui est mobile dans la direction de balayage prédéterminée tout en contenant un substrat sur lequel un motif sur le masque doit être transféré ;

    dans lequel chacun de l'étage de masque et de l'étage de substrat comprend un étage de mouvement fin qui est mobile par rapport à l'étage de masque et à l'étage de substrat, respectivement ;
    un premier dispositif de mesure pour mesurer la position, dans la direction de balayage prédéterminée, de l'étage de mouvement fin pour l'étage de masque,
    un deuxième dispositif de mesure pour mesurer la position, dans la direction de balayage prédéterminée, de l'étage de mouvement fin pour l'étage de substrat,
    un dispositif pour commander la position de chaque étage de mouvement fin par un procédé à rétroaction en correspondance avec une différence entre la position mesurée par le premier dispositif de mesure et la position mesurée par le deuxième dispositif de mesure pendant l'exposition de balayage.

2. Appareil d'exposition du type à balayage selon la revendication 1, dans lequel lesdits premier et deuxième dispositifs de mesure comprennent un système d'interféromètre.

3. Appareil d'exposition du type à balayage selon la revendication 1 ou 2, dans lequel l'étage de substrat se déplace dans une direction opposée au mouvement de l'étage de masque.

# FIG. 1

*FIG. 2A*

13Y1 — 13Y2

LWY1   IL   LWY2

7Y

7X

6

32W

LWX

IL

5

LWoF

34

4

Y

X

*FIG. 2B*

14y2 — 14y1

38   23   39

25

LRy2   24   LRy1

21y2   21y1

12

LRx

21x

11

Y

10   32   X

# FIG. 3

# FIG. 4

## FIG. 5A

## FIG. 5B

## FIG. 6